# EUROPÄISCHE PATENTANMELDUNG

(11) **EP 1 204 137 A2**
(43) Veröffentlichungstag der Anmeldung: **08.05.2002**
(21) Anmeldenummer: 01126180.7
(22) Anmeldetag: 05.11.2001
(51) Int. Cl.: H01L 21/60

(54) **Verfahren und Vorrichtung zum Kontaktieren von Halbleiterchips**

(30) Priorität: 06.11.2000 DE 10054884
(71) Anmelder: Michalk, Manfred, Dr., D-99096 Erfurt (DE)
(72) Erfinder: Michalk, Manfred, Dr., D-99096 Erfurt (DE)
(74) Vertreter: Liedtke, Klaus, Dr.

(57) **Zusammenfassung**

2.1 Der Erfindung liegt die Aufgabe zugrunde, ein Verfahren und eine Anordnung anzugeben, die eine sehr hohe Flip-Chip-Bondproduktivität bei sehr guter Kontaktqualität ermöglichen, ohne dass ein Einsatz einer Vielzahl von singulären Thermoden erforderlich ist.
2.2 Erfindungsgemäß gelingt die Lösung der Aufgabe dadurch, dass die vorgesehene Anzahl von Halbleiterchips gemeinsam mit einem Chipfixiertool fixiert wird, wobei die Halbleiterchips in einer Zwischenablage so angeordnet werden, dass sie der künftigen Halbleiterchipmusteranordnung auf dem Substrat entsprechen, danach die Halbleiterchips in der Halbleiterchipmusteranordnung mittels eines Chiptransfertools auf den Abschnitt des Substrates gesetzt werden und anschließend mit dem Chipfixiertool der Kleber unter Temperatur- und Druckeinwirkung ausgehärtet wird und so die Halbleiterchips dauerhaft elektrisch und mechanisch auf den Chipbondpositionen des Substrates kontaktiert werden und dass die Vorrichtung eine Zwischenablage, ein Chiptransfertool und ein Chipfixiertool enthält, wobei das Chiptransfertool Aufnahmen für ein oder mehrere Halbleiterchips aufweist und das Chiptransfertool Kanäle enthält, mit denen die Halbleiterchips angesaugt werden, und wobei das Chipfixiertool beheizbar ist und Anschläge aufweist, mit denen es auf dem Abschnitt des Substrates und/oder auf die Substratauflage aufgesetzt wird.
2.3 Die Erfindung betrifft ein Verfahren und eine Vorrichtung zum Kontaktieren von Halbleiterchips auf einem flexiblen Substrat, auf dem geflipte Halbleiterchips mittels Kleber befestigt werden, wobei ein Abschnitt des Substrates auf einer Substratauflage zeitweilig gelagert wird und eine vorgegebene Anzahl von Halbleiterchips mit ihrer aktiven Chipseite mittels flüssigem oder pastösem Kleber auf vorgesehenen Chipbondpositionen positioniert werden.

## Beschreibung

Die Erfindung betrifft ein Verfahren und eine Vorrichtung zum Kontaktieren von Halbleiterchips auf einem flexiblen Substrat, auf dem geflipte Halbleiterchips mittels Kleber befestigt werden, wobei ein Abschnitt des Substrates auf einer Substratauflage zeitweilig gelagert wird und eine vorgegebene Anzahl von Halbleiterchips mit ihrer aktiven Chipseite mittels flüssigem oder pastösem Kleber auf vorgesehenen Chipbondpositionen positioniert werden.

Im Stand der Technik werden üblicherweise hierzu das Chip-Bond-Verfahren oder das so genannte Flip-Chip-Bond-Verfahren angewendet.

Beim Kontaktieren von Halbleiterchips nach dem Chip-Bond-Verfahren (Die Bonding), insbesondere beim flächigem Verbinden der Chiprückseite (die der aktiven Fläche gegenüberliegende Fläche) mit einem Chipträger sind die im Folgenden beschriebenen Verfahrensweisen üblich.

Der Chipträger wird im vorgegebenen Bereich eines Bondgerätes und ein Halbleiterchip wird in einer exakt vorgegebenen Lage im Bondgerät positioniert. Danach erfolgt der Auftrag von Kleber in vorgegebener Menge auf den Chipträger. Das Halbleiterchip wird aus der vorgegebenen Lage im Bondgerät entnommen; dabei kann je nach verwendeter Zuführung der Halbleiterchips das Chip von einem Gelpack, aus einem Blistergurt, aus einem Waffelpack oder aus dem trenngeschliffenen und geringfügig aufgespreizten Waferverband bzw. aus einer sich anschließenden Zentrierstation entnommen werden. Danach erfolgt das Absetzen und ein leichtes Andrücken des Halbleiterchips auf dem bzw. in das Kleberbett des Chipträgers. Bei einer Abwandlung des Verfahrens und der zugehörigen apparatetechnischen Anordnung wird der Kleber nicht auf dem Chipträger aufgetragen, sondern die Chiprückseite des auf der aktiven Seite mit einem speziellen Ansaugwerkzeug festgehaltenen Chips mittels eines Dipping-Vorganges (kurzes Tauchen in einen Klebervorrat) mit Kleber beschichtet und danach auf den Chipträger abgesetzt. Unabhängig davon, welches Kleberauftragsverfahren gewählt wurde, erfolgt anschließend stets ein Härten des Klebers mit einem vorgegebenen Temperatur-Zeit-Prozess in einer nachfolgenden Station.

Beim Flip-Chip-Bonden mittels Kleber wird nach dem Entnehmen der Chips aus der vorgegebenen Lage im Bonder die aktive Chipflächenseite, die bei der Entnahme nach oben (zum Entnahmewerkzeug) zeigt, um 180° nach unten gedreht. Vor, während oder nach diesem so genannten Flip-Vorgang erfolgt meist eine nochmalige Positionsbestimmung und Lageausrichtung des Chips. Auf die exakt positionierte Schaltung wird der vorgesehene Kleber als Klebepaste oder Klebefilm aufgetragen bzw. der geflipte Chip wird mit seiner aktiven Seite in einen bereitgestellten Kleber gedipt. Ausschließlich erfolgt das Absetzen des Chips mit der aktiven Seite auf die Schaltung, so dass die Kontakthügel (Bumps) des Chips auf den vorgesehenen Kontaktflächen der chipaufnehmenden Schaltung liegen. Im Gegensatz zum Chipbonden muss während des gesamten anschließenden Kleberhärteprozesses ständig ein vorgegebener Druck auf den Chip ausgeübt werden, damit die Kontakthügel des Chips ständig im Presskontakt, z.T. über elastische, elektrisch leitende Füllstoffe des Klebers, mit den Kontaktflächen der Schaltung bleiben und der Presskontakt durch den gehärteten Kleber in einen elektrischen Dauerkontakt umgewandelt (eingefroren) wird.

Da diese Härtezeit erheblich die Produktivität des Flip-Chip-Bonders herabsetzt, werden zwei Lösungswege beschritten, um die Produktivität zu erhöhen:

Zum einen werden Kleber eingesetzt, die eine extrem kurze Härtezeit aufweisen (z.B. 1,5 s.). Dabei ist das Chipansaugwerkzeug, welches den Chiptransport zur Schaltung ausführt, geheizt und verbleibt mit definiertem Druck während des Härteprozesses auf dem Chip.
Nachteilig ist hierbei, dass die extrem schnell härtenden Kleber andere wichtige Eigenschaften wie Festigkeit, Haftungsvermögen, Feuchtedichte, angepasster Ausdehnungskoeffizient im allgemeinen nicht optimal erreichen und dass diese Kleber bei Härtungsbeginn schlagartig Restfeuchte oder Gase freisetzen können, die die Homogenität der Klebung erheblich negativ beeinflussen.

Eine andere Lösung besteht darin, die Chips im Kleberbett abzusetzen, die Schaltung weiterzutransportieren und in einer gesonderten Härtevorrichtung, die dem eigentlichen Bondapparat nachgelagert ist, mindestens von der Chipseite her (und unterstützend auch von der Schaltungsseite her) eine Thermode auf jedes Chip aufzusetzen und mittels Druck und Temperatur den Kleber bei Härtezeiten bis 10 Sekunden auszuhärten. Einer Chipbondposition muss hierbei eine Vielzahl von Härtepositionen nachgelagert werden.
Nachteilig bei dieser Lösung ist, dass die Anordnung einer Vielzahl von Thermoden sehr volumen- und kostenintensiv ist und das beim Transport der Schaltung von Bondpositionen zu Härtungspositionen die Chips auf der Schaltung verrutschen können.

Der Erfindung liegt die Aufgabe zugrunde, ein Verfahren und eine Anordnung der eingangs genannten Art anzugeben, die eine sehr hohe Flip-Chip-Bondproduktivität bei sehr guter Kontaktqualität ermöglichen, ohne dass ein Einsatz einer Vielzahl von singulären Thermoden erforderlich ist.

Erfindungsgemäß wird die Aufgabe mit einem Verfahren, welches die in Anspruch 1 angegebenen Merkmale und mit einer Vorrichtung, welche die in Anspruch 5 angegebenen Merkmale enthält, gelöst.

Vorteilhafte Ausgestaltungen sind in den Unteransprüchen angegeben.

Bei der erfindungsgemäßen Vorrichtung werden:

Die Chips nach der Entnahme aus dem Waferverband (oder aus einer anderen Abholposition) im geflipten Zustand exakt so in einer Zwischenablage ablegt, wie es dem Anordnungsmuster der Chips auf der künftigen Schaltung oder auf einem Abschnitt eines Schaltungsträgers entspricht.

Der flexible Schaltungsträger ist auf allen chipzubondenden Positionen mit Klebepaste, Klebefolienstücken oder ähnlichem Chipfixiermaterial versehen. Die Chips werden mit einem einteiligen Umsetzwerkzeug (Multitool) aus der Zwischenablage kollektiv entnommen und kollektiv auf die künftige Schaltung oder den Schaltungsträgerabschnitt gesetzt.

Es ist auch möglich, dass die Chips mit einem einteiligen Umsetzwerkzeug (Multitool) aus der Zwischenablage entnommen und kollektiv mit der dem Multitool abgewandten aktiven Seite in das Chipfixiermittel (Kleber) gedipt und danach mit dem Multitool auf die Schaltung oder den Schaltungsträgerabschnitt abgesetzt werden.

Für den Härteprozess kann entweder ein geheiztes Multitool die Chips solange gegen die Schaltung pressen bis das Fixiermittel (Kleber) ausgehärtet ist oder das Multitool wird abgehoben und ein geheiztes einteiliges Thermodentool wird nachfolgend auf die Chips aufgesetzt. Das Thermodentool presst die Chips solange gegen die Schaltung, bis das Fixiermittel (Kleber) ausgehärtet ist. In letzteren Fall kann das chipabsetzende Tool gegebenenfalls auch nur je ein Chip ablegen. Chipablegendes Tool und chipanpressendes und kleberausheizendes Tool können jeweils unterschiedliche Chipanzahlen bearbeiten.
Beim Ausheizen kann auch ein Anlöten der Chipkontakthügel an die Schaltung erfolgen.

Um den Chipanpressdruck für jeden Chip im vorgegebenen Bereich zu halten, ist zumindest in der Chipanpress- und Härtephase durch chipindividuelle Druckstempel, die auf die Unterseite des flexiblen Schaltungsträgers (Chipsubstrats) exakt unter jeder der vorgesehenen Chipbondstellen drücken, über das Chipsubstrat das Chip gegen das beheizte Tool zu drücken. Der Stempeldruck kann durch mechanische Federn oder durch hydraulische und/oder pneumatische Kräfte auf die Stempel erzielt und eingestellt werden.

Die erfindungsgemäße Anordnung zeichnet sich durch eine Reihe von Vorteilen aus. Hierzu gehören insbesondere:
- Sie ermöglicht eine starke apparatetechnische Vereinfachung des Chipkleberhärtens bei gleichzeitigem planparallelem Anpressen der Chips an den flexiblen Schaltungsträger (Substrat). Das Maschinenvolumen und die Maschinenkosten sinken damit drastisch.
- Es wird eine hohe Dichte von Chips pro Substratfläche bei hoher Bondproduktivität erreicht bzw. ermöglicht.
- Die Anordnung gewährleistet eine sehr schonende Chipbehandlung beim Chipabsetzen und Fixieren, da durch die kollektive Chipbehandlung (> 5.....30 Chips pro Tool) die Chipabsetzphase bei gegenüber der Singlechipbehandlung höherer Produktivität langsamer ablaufen kann und da in jeder Phase des Chipabsetzens und Kleberaufschmelzens bzw. Kleberaushärtens oder Lötens die Anpresskraft des Chips gegen das Substrat steuerbar ist.
- Es können Kleber mit längeren Ausheizzeiten verwendet und damit qualitativ hochwertige Klebeergebnisse erzielt werden
- Wegen der allgemein sehr geringen Dickentoleranz der Chips und des Schaltungsträgers (Substrat) sind nur geringe Druckstempelhübe erforderlich.

Die Erfindung wird nachfolgend an einem Ausführungsbeispiel näher beschrieben. In der zugehörigen Zeichnung zeigen:
- Figur 1: einen Abschnitt aus einem flexiblen bandförmigen Substrat mit den vorgesehenen Chipbondstellen in Draufsicht,
- Figur 2: eine Chip-Zwischenablage in Draufsicht,
- Figur 3: Substrat, Chips und Chiptransfertool in einer geschnittenen Seitenansicht,
- Figur 4: Substrat, Chips, Chipfixiertool und Pressstempel in einer geschnittenen Seitenansicht.

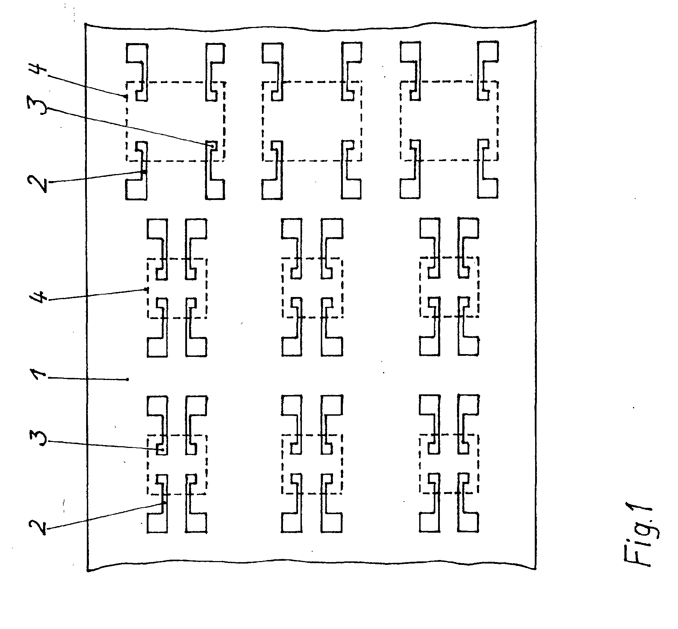

Figur 1 zeigt einen Ausschnitt aus einem flexiblen bandförmigen Substrat 1. Das Substrat 1 besteht im Beispiel aus 50 µm dickem Polyester. Das Substratband 1 trägt auf seiner Oberseite Leiterbahnen 2 aus 15 µm dickem, nassätzstrukturierten Kupfer. Die Leiterbahnen 2 enden in Chipkontaktflächen 3, die innerhalb der künftigen Chipbondpositionen 4 liegen.

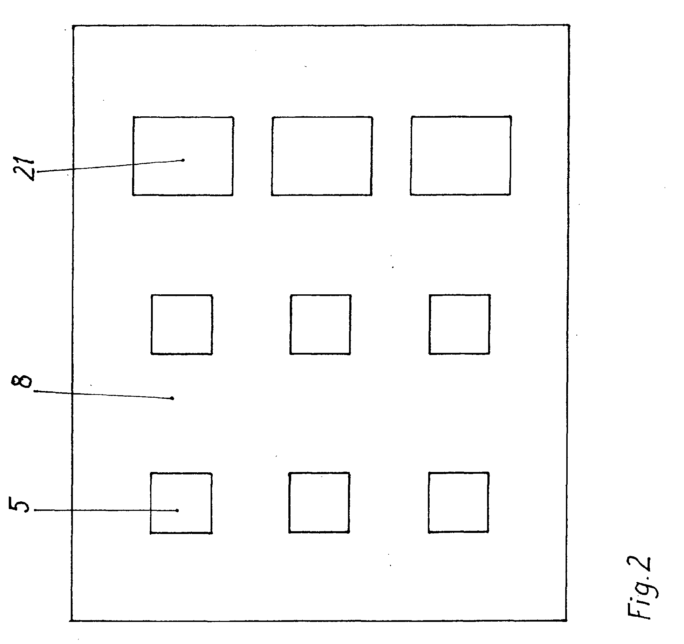

Die Chips 5 und 21, deren aktive Seite 6 nach unten zeigt, sind in Figur 2 auf der Zwischenablage 8 so angeordnet, dass ihre Lage zueinander exakt der künftigen Chiplage entspricht, wie sie nach der in Figur 1 dargestellten Chipbondpositionen 4 vorgegeben ist.
Auf sechs Positionen 4 sind Chips 5 vom Typ A abgelegt, auf drei Positionen sind die flächenmäßig größeren Chips 21 vom Typ B abgelegt. Die Zwischenablage 8 ist eine sehr starr im Bondgerät angeordnete, waagerechte Tischfläche. Die Tischfläche kann weitere mechanische Elemente (Saugkanäle, chipflächengroße Vertiefungen usw.) zur besseren Zwischenfixierung der Chips 5, 21 aufweisen.

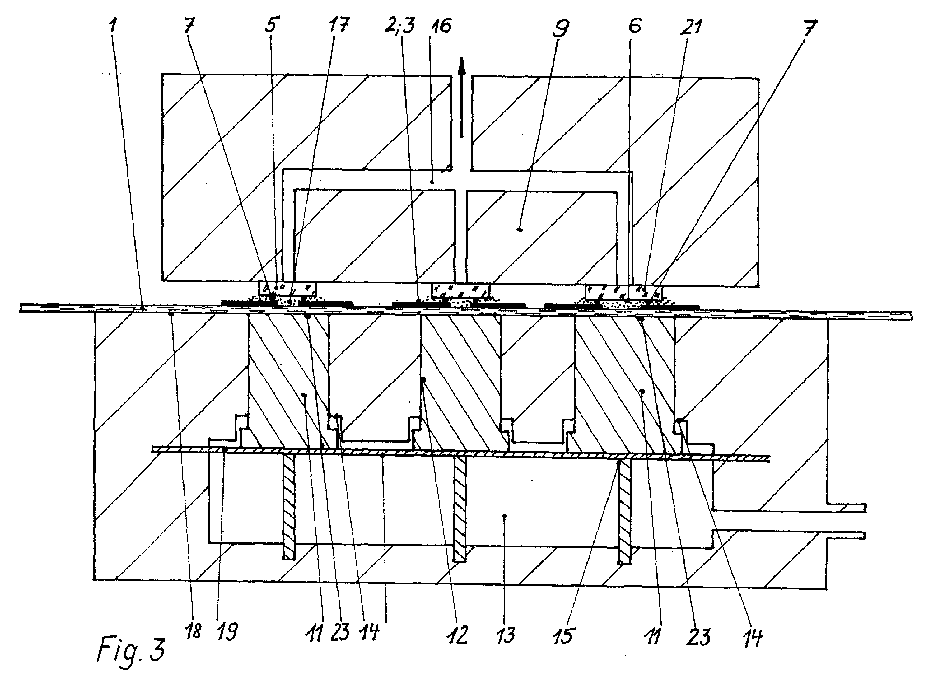

Figur 3 zeigt die Chips 5 ; 21 in Seitenansicht, nachdem alle neun Chips 5, 21 vom Chiptransfertool 9 gemeinsam durch Ansaugen mittels der Kanäle 16 aufgenommen, zum Substratabschnitt 1 transportiert und dort auf den jeweiligen Chipbondpositionen 4 abgesetzt wurden. Das Substrat 1 liegt mit seiner Unterseite auf der Substratauflage 18 auf. Das Substrat 1 ist innerhalb der Fläche der Chipbondpositionen 4 zuvor mit Kleber 17 beschichtet worden.

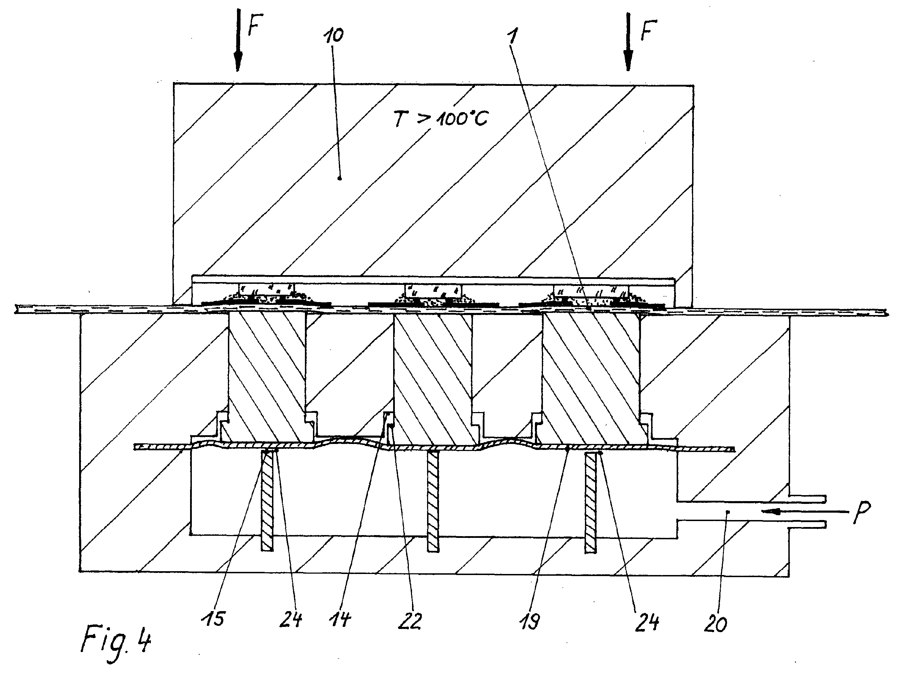

Wie aus den Figuren 3 und 4 ersichtlich ist, sind in der Substratauflage 18 lagedeckungsgleich zu den Chipbondpositionen 4 senkrechte Löcher rechteckigen Querschnitts eingearbeitet, die als Pressstempelaufnahme 12 für die in ihnen leicht gleitenden Pressstempel 11 dienen. Die Pressstempel 11 tragen am unteren Ende einen Kragen 22. Der Kragen 22 gewährleistet zusammen mit dem oberen Pressstempelanschlag 14, dass die dem Chip 5, 21 zugewandte Pressfläche 23 nur soweit aus der Substratauflage 18 herausgeschoben werden kann, wie dies nach den jeweiligen Materialtoleranz- und Maschinentoleranzgründen maximal erforderlich ist. Im Beispiel ist der maximale Überstand von Pressfläche 23 über die Substratauflage 18 auf 150 µm begrenzt. Andererseits kann die unterste Höhenstellung der Pressfläche 23 nicht tiefer sein als die Flächenebene der Substratauflage 18. Der untere Pressstempelanschlag 15 verhindert ein Durchfallen des Pressstempels 11 in die Druckkammer 13 der Substratauflage 18. Die Pressstempel 11 werden über eine in sich leicht bewegliche Membran 19, die an der Oberseite der Druckkammer 13 eingespannt ist und die die Druckkammer 13 gegen die Pressstempelaufnahmen 12 abdichtet, nach oben bewegt, sobald die Druckkammer 13 über den Druckkanal 20 mit Gas- oder Flüssigkeitsdruck beaufschlagt wird. Der Maximalhub der Stempel 11 beträgt im Beispiel 150 µm. Unabhängig davon, welche Dickentoleranz das Substrat 1, die Chips 5 ;21 und die Kontakthügel 7 aufweisen und welche Höhenlagetoleranzen des Chiptransfertool 9 oder die Substratauflage 18 aufweisen, gleiten die Pressstempel 11 nach oben und drücken das Substrat 1 gegen die Chips 5 ;21, sobald im Chipabsetzfall die Druckkammer 13 unter Druck gesetzt wird. Mit Hilfe einer Drucksteuerung kann der Anpressdruck und die Anpressgeschwindigkeit in vorgegebenen Grenzwerten gehalten werden.
Nach dem Chipabsetzen wird das Chiptransfertool 9 entfernt und anschließend das Chipfixiertool 10 aufgesetzt. Diese Position ist in Figur 4 dargestellt. Das Fixiertool 10 wird über Anschläge 24 mit hoher Kraft auf den Substratabschnitt 1 bzw. die Substratauflage 18 aufgesetzt.
Das Fixiertool 10 kann an den Stellen, an denen es mit den Chips 5 ;21 oder Chipkleber 17 in Berührung kommt, zumindest temporär mit Antihaftmitteln beschichtet oder belegt sein. Sobald das Fixiertool 10 aufgesetzt wird, wird wiederum über den Druckkanal 20 die Druckkammer 13 mit Gas- oder Flüssigkeitsdruck beaufschlagt und die Membran 19 sowie die Pressstempel 11 werden nach oben gedrückt. Jedes Chip 5, 21 wird unabhängig von den jeweiligen Dicken- und Höhentoleranzen mit der gleichen, vorgegebenen Anpresskraft an das Substrat 1 gedrückt. Sollen Chips 5, 21 unterschiedlicher Größe oder mit unterschiedlichen Anzahlen der Kontakthügel 7 verarbeitet werden, wird dies über die Pressflächenquerschnitte 23 konstruktiv berücksichtigt. Bei Bedarf können die Substratauflage 18 und der Pressstempel 11 ebenfalls beheizt werden. Nach erfolgtem Aushärten des Klebers 17 wird das Chipfixiertool 10 entfernt und der Substratabschnitt 1 weitertransportiert.

Im Beispiel ist ein Ablauf dargestellt, bei dem
1. Der Kleber 17 in einer der Bondstation vorgelagerten Station als Paste aufgetragen wird.
2. Das Chip 5 des Typ A und das Chip 21 des Typ B auf einer Zwischenablage 8 deckungsgleich zu den künftigen Chipbondpositionen 4 des Substratabschnitts 1 angeordnet und danach gemeinsam vom Transfertool 9 aufgenommen und auf dem Substratabschnitt 1 in das Kleberbett 17 der jeweiligen Chipbondpositionen 4 übertragen wurden bei gleichzeitiger Druckunterstützung der höhenveränderbaren Pressstempel 11.
3. Anschließend bewirkte das Fixiertool 10 die Aushärtung des Chipklebers 17 unter gleichzeitigem Anpressen der Chips 5; 21 durch die Pressstempel 11 an das Substrat 1.

Je nach konkreter Auslegung von Verfahren **und** Maschinenanordnung können weitere Verfahrensabläufe verwirklicht werden. Beispielsweise ist es möglich, die Chips 5; 21 seriell (jedes für sich) auf dem Substrat 1 abzulegen, danach erfolgt das Ausheizen mit einem mehrere Chips 5; 21 umfassenden Fixiertool 10 und entsprechender Steuerung der Pressstempel 11.
Die Chips 5; 21 können auch gemeinsam von der Zwischenablage 8 auf das Substrat 1 abgesetzt werden und das Fixiertool 10 übernimmt gleichzeitig die Chiptransferfunktion bzw. das Chiptransfertool 9 übernimmt auch die Fixierfunktion.

### BEZUGSZEICHENLISTE

- 1: Substrat
- 2: Leiterbahnen
- 3: Chipkontaktflächen
- 4: Chipbondposition
- 5: Chip Typ A
- 6: Aktive Chipseite
- 7: Kontakthügel (Bump)
- 8: Zwischenablage
- 9: Chiptransfertool
- 10: Chipfixiertool
- 11: Pressstempel
- 12: Pressstempelaufnahme
- 13: Druckkammer der Substratauflage
- 14: oberer Pressstempelanschlag
- 15: unterer Pressstempelanschlag
- 16: Saugkanal
- 17: Kleber
- 18: Substratauflage
- 19: Membran
- 20: Druckkanal
- 21: Chip Typ B
- 22: Pressstempelkragen
- 23: Pressfläche
- 24: Fixiertoolanschlag

## Patentansprüche

1. Verfahren zum Kontaktieren von Halbleiterchips (5; 21) auf einem flexiblen Substrat (1), auf dem geflipte Halbleiterchips (5; 21) mittels Kleber (17) befestigt werden, wobei ein Abschnitt des Substrates (1) auf einer Substratauflage (18) zeitweilig gelagert wird und eine vorgegebene Anzahl von Halbleiterchips (5; 21) mit ihrer aktiven Chipseite (6) mittels flüssigen oder pastösem Kleber (17) auf vorgesehenen Chipbondpositionen (4) positioniert werden, **dadurch gekennzeichnet, dass** die vorgesehene Anzahl von Halbleiterchips (5; 21) gemeinsam mit einem Chipfixiertool (10) fixiert wird, wobei die Halbleiterchips (5; 21) in einer Zwischenablage (8) so angeordnet werden, dass sie der künftigen Halbleiterchipmusteranordnung auf dem Substrat (1) entsprechen, danach die Halbleiterchips (5; 21) in der Halbleiterchipmusteranordnung mittels eines Chiptransfertools (9) auf den Abschnitt des Substrates (1) gesetzt werden und anschließend mit dem Chipfixiertool (10) der Kleber (17) unter Temperatur- und Druckeinwirkung ausgehärtet wird und so die Halbleiterchips (5; 21) dauerhaft elektrisch und mechanisch auf den Chipbondpositionen (4) des Substrates (1) kontaktiert werden.

2. Verfahren nach Anspruch 1, **dadurch gekennzeichnet, dass** die vorgesehene Anzahl von Halbleiterchips (5; 21) mittels eines beheizten Chipfixiertools (10), das gegen Anschläge (24) auf die Rückseite der Halbleiterchips (5; 21) aufgesetzt wird und dass mittels unter jeder Chipbondposition (4) des Substratabschittes (1) in der Substratauflage (18) angebrachter, höhenstellbarer, druckgesteuerter Pressstempel (11) danach die Halbleiterchips (5; 21) über den direkt über der Pressfläche (23) liegenden Flächenteil des Substratabschnittes (1) und weiter über die auf der aktiven Chipseite (6) befindlichen Kontakthügel (7) gegen das Chipfixiertool (19) gepresst werden.

3. Verfahren nach Anspruch 2, **dadurch gekennzeichnet, dass** das Absetzen der Halbleiterchips (5; 21) auf den Chipbondpositionen (4) durch vor oder während des Absetzens mit geringem Druck höhenverstellter Pressstempel (11) und entsprechend höhenverstellter Chipbondpositionen (4) erfolgt.

4. Verfahren nach einem der Ansprüche 1 bis 3, **dadurch gekennzeichnet, dass** die Kraft- und Temperatureinwirkung über eine Druck-Zeit-Steuerung während des Fixierens und Kontaktierens der Chips (5; 21) auf dem Substrat (1) gesteuert wird.

5. Vorrichtung zum Kontaktieren von Halbleiterchips (5; 21) auf einem Abschnitt eines Substrates (1), der auf einer Substratauflage (18) zeitweilig gelagert wird und die mit einer Einrichtung zum Zwischenlagern, Transportieren und zur Positionieren der Halbleiterchips (5; 21) versehen ist, **dadurch gekennzeichnet, dass** die Vorrichtung eine Zwischenablage (8), ein Chiptransfertool (9) und ein Chipfixiertool (10) enthält, wobei das Chiptransfertool (9) Aufnahmen für ein oder mehrere Halbleiterchips (5; 21) aufweist und das Chiptransfertool (9) Kanäle (16) enthält, mit denen die Halbleiterchips (5, 21) angesaugt werden, und wobei das Chipfixiertool (10) beheizbar ist und Anschläge (24) aufweist, mit denen es auf dem Abschnitt des Substrates (1) und/oder auf die Substratauflage (18) aufgesetzt wird.

6. Vorrichtung nach Anspruch 5, **dadurch gekennzeichnet, dass** in der Substratauflage (18) lagedeckungsgleich zu den Chipbondpositionen (4) höhenverstellbare, druckgesteuerte Pressstempel (11) angeordnet sind und sich unterhalb der Substratauflage (18) eine Druckkammer (13) befindet, und durch Druckbeaufschlagung die Pressstempel (11) bewegt werden, und an der Oberseite der Druckkammer (13) eine Membran (19) zur Dichtung der Druckkammer (13) eingespannt ist.

7. Vorrichtung nach Anspruch 6, **dadurch gekennzeichnet, dass** die Pressstempel (11) an ihren unteren Enden einen Kragen (22) aufweisen.

8. Vorrichtung nach einem der Ansprüche 5 bis 7, **dadurch gekennzeichnet, dass** das Fixiertool (10) an den Stellen, an denen es mit den Chips (5; 21) oder mit Chipkleber (17) in Berührung kommt, mit Antihaftmitteln beschichtet ist.

9. Vorrichtung nach einem der Ansprüche 6 bis 8, **dadurch gekennzeichnet, dass** die Substratauflage (18) und die Pressstempel (11) beheizbar sind.
